(19) Europäisches Patentamt

European Patent Office

Office européen des brevets

(11) **EP 0 718 935 A2**

(12) **EUROPÄISCHE PATENTANMELDUNG**

(43) Veröffentlichungstag:
26.06.1996 Patentblatt 1996/26

(51) Int. Cl.⁶: **H01S 3/06**, H01S 3/094

(21) Anmeldenummer: 95119797.9

(22) Anmeldetag: 15.12.1995

(84) Benannte Vertragsstaaten:
**CH DE ES FR GB IT LI SE**

(30) Priorität: **24.12.1994 DE 4446524**

(71) Anmelder: **Alcatel SEL Aktiengesellschaft
D-70435 Stuttgart (DE)**

(72) Erfinder: **Fritschi, Rainer
D-70825 Korntal (DE)**

(74) Vertreter: **Schätzle, Albin, Dipl.-Phys. et al
Alcatel SEL AG
Patent- und Lizenzwesen,
Postfach 30 09 29
D-70449 Stuttgart (DE)**

(54) **Faseroptischer Verstärker**

(57) Bei einem optischen Verstärker, der zwei Pumplichtquellen hat, besteht das Problem, daß u.U. ein (oder beide) Laser beschädigt wird, wenn der Laserstrom über einen Grenzwert hinweg erhöht wird. Vor allem dann, wenn alterungsbedingt der Wirkungsgrad eines Lasers abnimmt, kann es vorkommen, daß ein Laser überlastet wird.

Der optische Verstärker hat für jede Pumplichtquelle (LM1, LM2) eine Regeleinrichtung (11,7) und eine Bewertungseinrichtung (13,14), die ein vom verstärkten optischen Signal abgeleitetes Steuersignal (D) mit einem in ihr festgelegten Bewertungsfaktor (F1, F2) bewertet. Diese Bewertungsfaktoren (F1, F2) sind unabhängig von der Alterung.

EP 0 718 935 A2

## Beschreibung

Die Erfindung betrifft einen optischen Verstärker gemäß dem Oberbegriff des Patentanspruchs 1.

Ein optischer Verstärker mit den im Oberbegriff angegebenen Merkmalen ist aus EP-A-0 395 277 bekannt. Der dort angegebene optische Verstärker ist ein faseroptischer Verstärker, der u.a. einen mit Erbium-Ionen dotierten Lichtwellenleiter, in dem ein Eingangssignal verstärkt wird, zwei Pumplichtquellen (Pumplaser) und einen Rückkoppelungskreis hat. Das Pumplicht wird dem mit Erbium-Ionen dotierten Lichtwellenleiter in Ausbreitungsrichtung des Eingangssignals und entgegen dessen Ausbreitungsrichtung zugeführt. Der Rückkoppelungskreis dient dazu, die Pumplichtquellen so zu regeln, daß die optische Leistung des Ausgangssignals konstant bleibt. Dazu wird ein Teil der optischen Leistung des Ausgangssignals ausgekoppelt, in ein der ausgekoppelten optischen Leistung entsprechendes elektrisches Signal gewandelt und dem Rückkoppelungskreis zugeführt. Die Pumplichtleistung kann dadurch so variiert werden, daß die optische Leistung des Ausgangssignals konstant bleibt. Einzelheiten des Rückkoppelungskreises sind nicht angegeben.

Bei einem solchen faseroptischen Verstärker kann es vorkommen, daß der Rückkoppelungskreis bei einem Abfall der optischen Leistung des Ausgangssignals oder bei einer Alterung der Pumplaser versucht, die Laserströme der beiden Pumplaser (und damit die Pumplichtleistung) über einen Grenzwert hinaus zu erhöhen, wodurch es zu einer Beschädigung eines (oder beider) Lasers kommen kann. Vor allem dann, wenn alterungsbedingt der Wirkungsgrad eines Lasers abnimmt, und wenn die beiden Laser unterschiedlich schnell altern, kann es vorkommen, daß ein Laser überlastet wird und dadurch noch schneller altert oder beschädigt wird.

Der Erfindung liegt die Aufgabe zugrunde, einen optischen Verstärker anzugeben, bei dem die genannten Probleme nicht bestehen. Ein die Aufgabe lösender optischer Verstärker ist Gegenstand des Patentanspruchs 1. Ausgestaltungen der Erfindung sind in den Unteransprüchen angegeben.

Ein Vorteil der Erfindung ist, daß die beiden Pumplaser voneinander unabhängig ausgewählt werden können, d.h. es können Pumplaser verwendet werden, die voneinander unterschiedliche optische Leistungen abgeben, obwohl durch jeden Pumplaser der gleiche Laserstrom fließt.

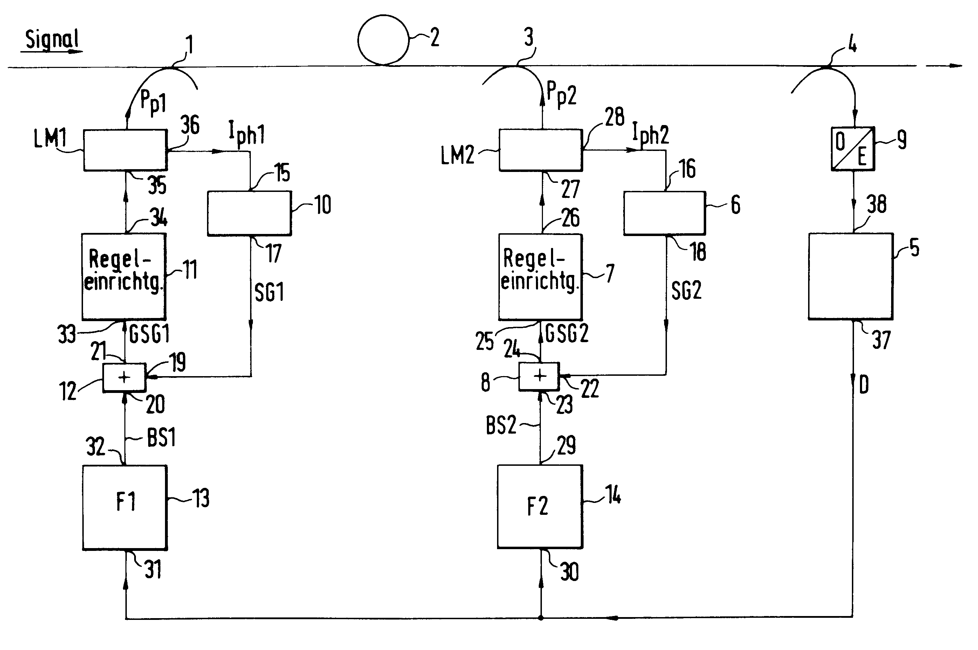

Die Erfindung wird im folgenden anhand einer einzigen Figur näher erläutert. Diese Figur zeigt eine schematische Darstellung eines erfindungsgemäßen faseroptischen Verstärkers.

Dieser erfindungsgemäße faseroptische Verstärker hat u. a. einen z.B. mit Erbium-Ionen dotierten Lichtwellenleiter 2, zwei Pumplichtquellen LM1, LM2 und zwei Koppeleinrichtungen 1, 3, die beispielsweise Faserschmelzkoppler sind. Die erste Koppeleinrichtung 1 koppelt das von der ersten Pumplichtquelle LM1 ausgesendete Pumplicht so in den dotierten Lichtwellenleiter 2 ein, daß es in diesem die gleiche Ausbreitungsrichtung wie ein in diesem zu verstärkendes optisches Signal hat. Die zweite Koppeleinrichtung 3 koppelt das von der zweiten Pumplichtquelle LM2 ausgesendete Pumplicht so in den dotierten Lichtwellenleiter 2 ein, daß es sich entgegen der Ausbreitungsrichtung des optischen Signals ausbreitet.

Die Pumplichtquellen LM1, LM2 sind üblicherweise sogenannte Lasermodule, die als lichtaussendendes Element einen Halbleiterlaser haben. Das vom Laser ausgesendete Pumplicht hat z.B. eine Wellenlänge von 980 nm. In einem solchen Lasermodul ist der Laser so angeordnet, daß an einer Seite des Lasers ein Lichtwellenleiter angekoppelt ist und an einer gegenüberliegenden Seite ein optoelektrischer Wandler, der für die weitere Beschreibung als Monitordiode bezeichnet wird. Diese Monitordiode liefert einen der Pumplichtleistung proportionalen Photostrom. Ein Lasermodul hat mehrere Anschlüsse, z.B. für die Zuführung des Laserstroms und für die Ableitung des Photostroms. In der Figur sind die beiden Pumplichtleistungen mit $P_{P1}$ und $P_{P2}$ und die beiden Photoströme mit $I_{Ph1}$ und $I_{Ph2}$ bezeichnet.

In dem gezeigten faseroptischen Verstärker gibt es für jede Pumplichtquelle LM1, LM2 einen Regelkreis, der dazu dient, die Pumplichtleistung $P_{P1}$, $P_{P2}$, der jeweiligen Pumplichtquelle LM1, LM2 konstant zu halten. Da beide Regelkreise einen gleichen Aufbau haben, erfolgt die Beschreibung anhand des Regelkreises der Pumplichtquelle LM1; die Bezugszeichen für den Regelkreis der Pumplichtquelle LM2 sind in Klammern angegeben. Ein Anschluß 36 (28) der Pumplichtquelle LM1 (LM2) ist mit einem Eingang 15 (16) eines Strom-Spannungswandlers 10 (6) verbunden, der den von der Monitordiode der Pumplichtquelle LM1 (LM2) erzeugten Photostrom $I_{Ph1}$ ($I_{Ph2}$) in eine Photospannung wandelt, die ein dem Photostrom $I_{Ph1}$ ($I_{Ph2}$) proportionales Stellsignal SG1 (SG2) ist.

Ein Ausgang 17 (18) des Strom-Spannungswandlers 10 (6) ist mit einem Eingang 19 (22) einer Addiervorrichtung 12 (8) verbunden.

Die Addiervorrichtung 12 (8) hat außerdem einen Eingang 20 (23) für ein Bewertungssignal BS1 (BS2) und einen Ausgang 21 (24) für ein Gesamtstellsignal GSG1 (GSG2), das aus der Addition des Stellsignals SG1 (SG2) und des Bewertungssignals BS1 (BS2) entsteht. Die beiden Bewertungssignale BS1, BS2 werden an anderer Stelle erläutert. Eine Addiervorrichtung ist aus dem Buch U. Tietze, C. Schenk, "Halbleiter-Schaltungstechnik", 8. Auflage, Springer-Verlag, Berlin, Heidelberg, New York, Kapitel 12.1, Seite 299 bekannt.

Der Ausgang 21 (24) der Addiervorrichtung 12 (8) ist mit einem Eingang 33 (25) einer Regeleinrichtung 11 (7) verbunden, die z.B. einen PI-Regler hat. Solche Regeleinrichtungen sind allgemein bekannt, z.B. aus dem Buch "Halbleiter-Schaltungstechnik", Kapitel 26, Seite 803 ff. Außerdem hat die Regeleinrichtung 11 (7) einen Spannungs-Stromwandler, der die vom PI-Regler abgegebene Steuerspannung in einen Steuerstrom wandelt. An einem Ausgang 34 (26) der Regeleinrichtung 11 (7), der mit einem zweiten Anschluß 35 (27) der Pumplichtquelle LM1 (LM2) verbunden ist, tritt der Steuerstrom aus, der zur Steuerung der Pumplichtleistung dient.

In dem faseroptischen Verstärker gibt es außer den beiden Regelkreisen einen Rückkoppelungskreis, der dazu dient, die Leistung des verstärkten optischen Signals konstant zu halten. Dafür hat der faseroptische Verstärker eine dritte Koppeleinrichtung 4, die einen Teil der optischen Leistung des verstärkten optischen Signals auskoppelt und einem damit verbundenen optoelektrischen Wandler 9 zuführt, der mit einem Eingang 38 eines Komparators 5 verbunden ist. Der optoelektrische Wandler 9 erzeugt einen der ausgekoppelten optischen Leistung proportionalen Photostrom, der durch einen im Komparator 5 enthaltenen Strom-Spannungswandler in eine Photospannung gewandelt wird. Der Komparator 5 vergleicht die Photospannung mit einer Referenzspannung. Besteht zwischen den beiden Spannungen eine Differenz, tritt an einem Ausgang 37 des Komparators 5 ein Steuersignal D aus, das proportional der Differenz ist. Der Ausgang 37 des Komparators 5 ist mit einem Eingang 31 einer ersten Bewertungseinrichtung 13 und mit einem Eingang 30 einer zweiten Bewertungseinrichtung 14 verbunden. Ein Ausgang 32 der ersten Bewertungseinrichtung 13 ist mit dem Eingang 20 der Addiervorrichtung 12 verbunden. Am Ausgang 32 tritt das bereits erwähnte Bewertungssignal BS1 aus. Ein Ausgang 29 der Bewertungseinrichtung 14 ist mit dem Eingang 23 der Addiervorrichtung 8 verbunden. Am Ausgang 29 tritt das bereits erwähnte Bewertungssignal BS2 aus.

Im folgenden werden die Bewertungseinrichtungen 13, 14 und die dort vorkommenden Bewertungssignale BS1, BS2 erläutert. Für jede Pumplichtquelle LM1, LM2 kann vor Inbetriebnahme des faseroptischen Verstärkers eine für jede Pumplichtquelle charakteristische Größe, die Monitordiodenempfindlichkeit $K_i$ (i= 1,2) gebildet werden. Diese Monitordiodempfindlichkeit $K_i$ ist der Quotient aus der Pumplichtleistung $P_{Pi}$ und dem Photostrom $I_{Phi}$ d.h. $K_i = P_{Pi}/I_{Phi}$ (i= 1,2) .

Diese Monitordiodenempfindlichkeit $K_i$ ist unabhängig von der Alterung des Halbleiterlasers. Nimmt die vom Laser ausgesendete Pumplichtleistung alterungsbedingt ab (obwohl der Laserstrom unverändert ist), nimmt auch der die Monitordiode erzeugte Photostrom in gleichem Maße ab; der Quotient und damit die Monitordiodenempfindlichkeit $K_i$ bleibt unverändert. Miteinander in Beziehung gesetzt, ergeben sich aus den beiden Monitordiodenempfindlichkeiten $K_i$ zwei Bewertungsfaktoren: $F1 = K_1 / (K_1 + K_2)$ und $F2 = K_2 / (K_1 + K_2)$ . Der Bewertungsfkator F1 ist somit der Quotient aus der Monitordiodenempfindlichkeit $K_1$ und der Summe der Monitordiodenemfindlichkeiten $K_1 + K_2$. Dies gilt auch für den Bewertungsfaktor F2. In jeder Bewertungseinrichtung 13, 14 ist der entsprechende Bewertungsfaktor gespeichert.

In der ersten Bewertungseinrichtung 13 wird das Steuersignal D mit dem ersten Bewertungsfaktor F1 bewertet d.h. multipliziert. Aus dieser Bewertung ergibt sich das bereits erwähnte Bewertungssignal BS1. Dem entsprechend wird in der Bewertungseinrichtung 14 das Steuersignal D mit dem zweiten Bewertungsfaktor F2 bewertet, so daß sich daraus das Bewertungssignal BS2 ergibt.

Bei dem im vorhergehenden beschriebenen faseroptischen Verstärker erfolgt die Regelung der optischen Leistung des verstärkten optischen Signals mit Hilfe von Bewertungsfaktoren, die unabhängig von der Alterung der verwendeten Laser sind. Durch die in diesen Bewertungsfaktoren enthaltenen Monitordiodenempfindlichkeiten $K_i$ werden Unterschiede (z.T. herstellungsbedingt) zwischen den Lasern ausgeglichen, d.h. es wird berücksichtigt, daß die Laser bei gleichem Laserstrom Licht unterschiedlicher optischer Leistung emittieren.

Die Beschreibung der Erfindung erfolgte anhand eines faseroptischen Verstärkers mit zwei Pumplichtquellen, in dem sich das Pumplicht in und entgegen der Ausbreitungsrichtung des Signals ausbreitet. Es sind auch zweistufige faseroptische Verstärker bekannt, in denen zwei mit Erbium-Ionen dotierte Lichtwellenleiter angeordnet sind, und in denen die Lichtwellenleiter jeweils von einer Pumplichtquelle Pumplicht in Ausbreitungsrichtung des Signals erhalten. An einem Ausgang eines solchen zweistufigen faseroptischen Verstärkers wird ein Teil des verstärkten optischen Signals ausgekoppelt und zu einer Regelung verwendet. Auch bei einem solchen zweistufigen faseroptischen Verstärker kann der im vorhergehenden beschriebene Rückkoppelkreis verwendet werden.

**Patentansprüche**

1. Optischer Verstärker zum Verstärken eines optischen Signals, der zwei Pumplichtquellen (LM1, LM2) und einen Rückkoppelungskreis zur Regelung der Pumplichtquellen (LM1, LM2) hat,
**dadurch gekennzeichnet, daß**
der Rückkoppelungskreis (5; 13, 11; 14, 7) für jede Pumplichtquelle (LM1, LM2) eine Regeleinrichtung (11, 7) und eine Bewertungseinrichtung (13, 14) hat, die ein vom verstärkten optischen Signal abgeleitetes Steuersignal (D) mit einem in ihr festgelegten Bewertungsfaktor (F1, F2) bewertet.

2. Optischer Verstärker nach Anspruch 1, dadurch gekennzeichnet,

    - daß jeder Bewertungsfaktor (F1, F2) eine Funktion von zwei Monitordiodenempfindlichkeiten ist,

    - daß die erste Monitordiodenempfindlichkeit der Quotient aus der von der ersten Pumplichtquelle (LM1) ausgesendeten Pumplichtleistung ($P_{P1}$) und einem von dieser Pumplichtquelle (LM1) in einem ersten optoelektrischen Wandler hervorgerufenen ersten Photostrom ($I_{Ph1}$) ist,

- daß die zweite Monitordiodenempfindlichkeit der Quotient aus der von der zweiten Pumplichtquelle (LM2) ausgesendeten Pumplichtleistung ($P_{P2}$) und einem von dieser Pumplichtquelle (LM2) in einem zweiten optoelektrischen Wandler hervorgerufenen zweiten Photostrom ($I_{Ph2}$) ist,

- daß der erste Bewertungsfaktor (F1) der Quotient aus der ersten Monitordiodenempfindlichkeit und der Summe der Monitordiodenempfindlichkeiten ist, und

- daß der zweite Bewertungsfaktor (F2) der Quotient aus der zweiten Monitordiodenempfindlichkeit und der Summe der Monitordiodenempfindlichkeiten ist.

3. Optischer Verstärker nach Anspruch 2, dadurch gekennzeichnet, daß für jede Pumplichtquelle (LM1, LM2) ein Regelkreis (10, 11; 6, 7) vorhanden ist, der die Pumplichtquelle (LM1, LM2) regelt.

4. Optischer Verstärker nach Anspruch 3, dadurch gekennzeichnet, daß jeder Regelkreis (10, 11; 6, 7) aus einem Strom-Spannungswandler (10, 6), der den Photostrom ($I_{Ph1}$, $I_{Ph2}$) in eine entsprechende Spannung wandelt, die ein Stellsignal (SG1, SG2) ist, und einer der Regeleinrichtungen (11, 7) besteht, die die Pumplichtquelle (LM1, LM2) in Abhängigkeit von dem Stellsignal (SG1, SG2) und dem Bewertungssignal (BS1, BS2) der Bewertungseinrichtung (13, 14) steuert.